# EUROPEAN PATENT APPLICATION

(11) **EP 4 187 602 A1**
(43) Date of publication of application: **31.05.2023**
(21) Application number: 22208340.4
(22) Date of filing: 18.11.2022
(51) Int. Cl.: H01L 27/02, H01L 29/87, H01L 29/06

(54) **A SEMICONDUCTOR DEVICE AND A METHOD OF MANUFACTURE**

(30) Priority: 29.11.2021 EP 21211007
(71) Applicant: Nexperia B.V., 6534 AB Nijmegen (NL)
(72) Inventor: Holland, Steffen, 22529 Hamburg (DE); Ritter, Hans-Martin, 22529 Hamburg (DE)
(74) Representative: Pjanovic, Ilija

(57) **Abstract**

This disclosure relates to a semiconductor device comprising at least three regions, wherein each region comprises a first-type layer doped with a first type of charge carriers and a second-type layer doped with a second type of charge carriers, wherein first-type layer and the second-type layer are positioned laterally along each region, wherein the first-type layer and the second-type layer have opposite polarity, wherein the first-type layer of a region is positioned substantially across the second-type layer of a neighboring region, and the second-type layer of a region is positioned substantially across the first-type layer of a neighboring region and wherein each region comprises a second-type well doped with the second type of charge carriers, wherein the second-type well is positioned around at least the first-type layer.

## Description

### TECHNICAL FIELD

The present invention relates to a method of forming a semiconductor device. The invention also relates to a method of manufacturing a semiconductor device.

### BACKGROUND OF THE DISCLOSURE

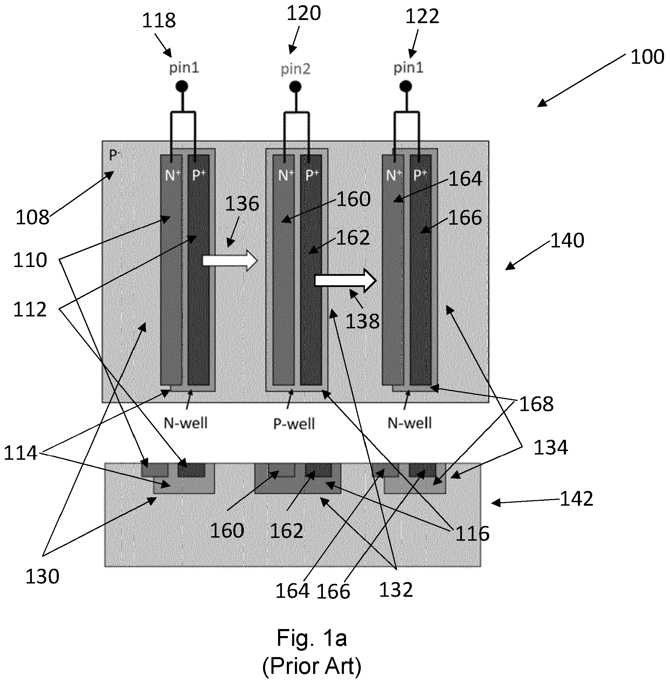

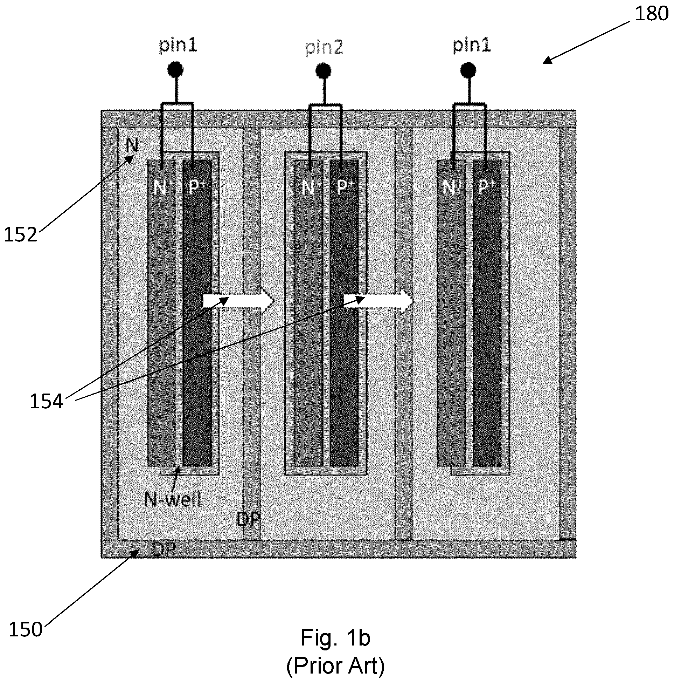

Known semiconductor devices are shown in Figures 1a and 1b.

A semiconductor device 100 shown in Figure 1a is shown from a top point of view, reference sign 140, and from a side point of view, reference sign 142. The semiconductor device comprises three regions, a first region 130, a second region 132, and a third region 134. These three regions 130, 132 and 134 are positioned horizontally next to each other, as shown in Figure 1a.

The semiconductor device comprises a P- area 108 wherein these three regions 130, 132 and 134 are positioned.

The first region 130 comprises a first N+ layer 110, a first P+ layer 112 and a first N-well 114 around the first P+ layer 112 and partially around the first N+ layer 110. The first N+ layer 110 and the first P+ layer 112 are of the same length and positioned parallel to each other.

The second region 132 comprises a second N+ layer 160, a second P+ layer 162 and a second P-well 116 around the second N+ layer 160 and partially around second P+ layer 162. The second N+ layer 160 and the second P+ layer 162 are of the same length and positioned parallel to each other.

The third region 134 comprises a third N+ layer 164, a third P+ layer 166 and a third N-well 168 around the third P+ layer 166 and partially around the third N+ layer 164. The third N+ layer 164 and the third P+ layer 166 are of the same length and positioned parallel to each other.

The semiconductor device further comprises three pins, a first pin 118 connected to the first region 130, a second pin 120 connected to the second region 132 and a third pin 122 connected to the third region 134.

Such positioning of N+ and P+ layers in the three regions shown in Figure 1a, secures that a current is flowing only from a P+ layer to a nearest N+ layer. i.e. from left to right in Figure 1a, as indicated with a first arrow 136. In the other direction there is a forward biased diode and the current flows in the same direction, but at a different location, as indicated with the second arrow 138.

Such a semiconductor device, known as a silicon controlled rectifier (SCR), is one-sided. The current can flow either in the direction indicated by the first arrow 136, or in the direction indicated by the second arrow 138. The current will always flow on one side of a region, not on both sides.

Another semiconductor device 180, also known in the art, is shown in Figure 1b. It is a variation of the semiconductor device 100 shown in Figure 1a. The differences in respect to the semiconductor device 100 shown in Figure 1a, are that the semiconductor device 180 shown in Figure 1b comprises a N- area 152, where the three regions are positioned. Furthermore, first and third region comprise a n well instead of a p well. The semiconductor device 180 shown in Figure 1b comprises a doping polarity isolation 150 around the three regions.

The semiconductor device 180 is also one-sided. The current flow in one direction is indicated by an arrow 154.

However, so-called System Level ESD Protection devices need to have a low capacitance. The arrangement of doping layers as in the prior art allows to reduce the capacitance of the device. SCRs are formed by a sequence of four layers, with the first and the third layer being doped with first type charge carriers (e.g. P type carriers), and the second and fourth layer being doped with second type charge carriers, different from the first type charge carriers, e.g. N type carriers. Typically, a known SCR is arranged in a so-called finger structure.

### SUMMARY OF THE DISCLOSURE

Various example embodiments are directed to the disadvantage as described above and/or others which may become apparent from the following disclosure.

According to an example of the disclosure, a semiconductor device is proposed, with the device comprising at least three regions, wherein each region comprises a first-type layer doped with a first type of charge carriers and a second-type layer doped with a second type of charge carriers, wherein the first-type layer and the second-type layer are positioned laterally along each region, wherein the first-type layer and the second-type layer have opposite polarity.

In particular, the first-type layer of a region is positioned substantially across the second-type layer of a neighboring region, and the second-type layer of a region is positioned substantially across the first-type layer of a neighboring region and wherein each region comprises a second-type well doped with the second type of charge carriers, wherein the second-type well is positioned around at least the first-type layer.

The alternate orientation of the multiple, so-called fingers / regions, with each finger/region being segmented in first-type and second-type layers result in segments functioning as a two-sided SCRs. Accordingly, a bidirectional SCR with lower capacitance is obtained.

Accordingly, and depending on the polarity of the first-type and second type charge carriers used, a current will flow within region being segmented in first-type and second-type layers result in segments functioning as a two-sided SCRs. Accordingly, a bidirectional SCR with lower capacitance is obtained.

Depending on the polarity used of the first-type and second-type charge carriers, current will either flow in the first segment (first layer) or in the second segment (second layer) formed. In particular, the current flows directly from the first-type/second-type layer of a region to the adjacent second-type/first-type layer of an adjacent region. The shorter this path the lower the resistance will be.

In a further example, in each region, the second-type well is continuous and thus also positioned around the second-type layer.

It should be noted, that for the semiconductor device, the first type of charge carriers may be P-type carriers, whereas the second type of charge carriers may be N-type carriers. However, the reversed configuration, wherein the first type of charge carriers are N-type carriers and the second type of charge carriers are P-type carriers is equally appliable in achieving the desired effect.

In an improved example, the semiconductor device furthermore comprises a first pin and a second pin, wherein the regions alternatingly are connected to the first pin and the second pin, respectively.

In an advantageous example of a semiconductor device according to the disclosure, the length of the first-type layer and the length of the second-type layer are about the same size.

Preferably, each region comprises N, with N a natural number greater than two (2), layers, which N layers are of the first-type layer and the second-type layer alternatively. The disclosure is not limited to three regions. The number of regions (fingers) can be four, five, six, seven, eight, or any other number, and preferably an odd number. Likewise, the number of segments (first-type and second type layers) can be any number N, but preferable an even number, hence an equal number of first-type and second-type layers alternatingly orientated in lateral direction along each region.

Alternatively, the semiconductor device comprises a first-type substrate doped with the first type of charge carriers and a first-type buried layer doped with the first type of charge carriers, wherein, in a preferred example, the doping of the first-type buried layer is higher than the doping of the first-type substrate.

In a further advantageous example, the semiconductor device comprises first-type deep wells doped with the first type of charge carriers between all the regions. These additional deep wells are advantageous when the doping level of the first-type substrate is so small, that without the deep wells punch-through effects would occur between the second-type dopings in neighboring regions. With the additional first-type deep wells the doping level of the substrate can be reduced to a very low level. This reduces the capacitance of the second-type well/substrate junction and of the second-type contact diffusion/substrate junction. This allows to reduce the overall capacitance of the whole device structure.

Preferably, the depth of the first-type deep wells is larger than the depth of the second-type wells.

Advantageously, the first-type buried layer is electrically connected with the first-type deep wells.

In a further example of a semiconductor device according to the disclosure, it comprises a second-type buried layer doped with the second type of charge carriers positioned below the first-type buried layer. Additionally, the semiconductor device may be placed on an oxide layer, which serves as an electrical isolation from the bottom side of the semiconductor device.

In a further example, each first-type layer and second-type layer is provided with at least one row of multiple spaced-apart electrically interconnected contact terminals. It has been found, that providing the multiple spaced-apart electrically interconnected contact terminals as rectangular contacts, this configuration offers the best compromise between current robustness and parasitic capacitance with current flowing to both sides of the contacts. In particular, each first-type layer and second-type layer is provided with two parallel rows of multiple spaced-apart electrically interconnected contact terminals. A dual row of contact terminals allows for more current in the contacts, however also the parasitic capacitance is larger because the contact diffusion has to be wide in order to accommodate the two rows of contact terminals. Rectangular contacts have a large current robustness, and the parasitic capacitance can be low because the contact diffusions can be narrower than with two rows of contacts.

The disclosure also pertains to a method of producing a semiconductor device as outlined in this patent application.

The above described embodiments of the present invention secure that the junction capacitance of the semiconductor device is reduced by at least 15-20% while the same ESD robustness of the semiconductor device is maintained.

Moreover, the layout of the semiconductor service becomes more symmetric and therefore the triggering of adjacent fingers/regions/layers of the semiconductor device is not dependent on the position of the first triggered finger/region/layer.

Such a laterally segmented layout of an SCR, as described in the above embodiments of the present invention, allows to reduce the capacitance of the ESD protection semiconductor device. In addition, it allows that the current spreading between the SCR fingers occurs more homogeneously.

### BRIEF DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1a and 1b show known semiconductor devices;
Figure 2 illustrates a semiconductor device according to an embodiment of the invention;
Figure 3 illustrates a semiconductor device according to an embodiment of the invention;
Figures 4a and 4b illustrate a semiconductor device according to an embodiment of the invention;
Figures 5a and 5b illustrate a semiconductor device according to an embodiment of the invention;
Figures 6a and 6b illustrate a semiconductor device according to an embodiment of the invention;
Figure 7 illustrates a semiconductor device according to an embodiment of the invention;
Figure 8 illustrates a semiconductor device according to an embodiment of the invention;
Figures 9A-9D illustrate a semiconductor device according to an embodiment of the invention;
Figures 10A-10C illustrate a semiconductor device according to an embodiment of the invention;
Figures 11A-11B illustrate a semiconductor device according to an embodiment of the invention;
Figures 12A-12B illustrate a semiconductor device according to an embodiment of the invention;
Figures 13A-13B illustrate a semiconductor device according to an embodiment of the invention;
Figures 14A-14B illustrate a semiconductor device according to an embodiment of the invention;
Figures 15A-15C illustrate a semiconductor device according to an embodiment of the invention.

### DETAILED DESCRIPTION OF THE DISCLOSURE

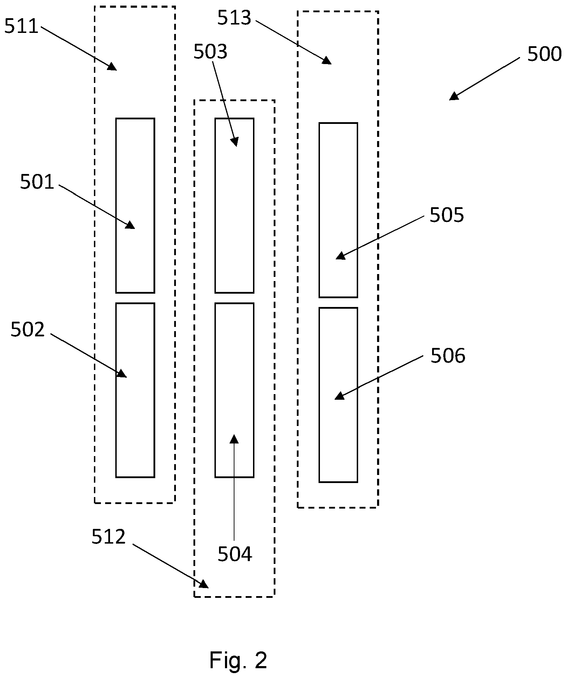

Figure 2 illustrates a semiconductor device 500 according to an embodiment of the present invention. The semiconductor device 500 comprises at least three regions, a first region 511, a second region 512, and a third region 513. The first region 511 comprises a first layer 501 and a second layer 502, wherein first layer 501 and the second layer 502 are positioned laterally along the first region 511, wherein the first layer 501 and the second layer 502 have opposite polarity. The second region 512 comprises a third layer 503 and a fourth layer 504, wherein third layer 503 and the fourth layer 504 are positioned laterally along the second region 512, wherein the third layer 503 and the fourth layer 504 have opposite polarity. The third region 513 comprises a fifth layer 505 and a sixth layer 506, wherein fifth layer 505 and the sixth layer 506 are positioned laterally along the third region 513, wherein the fifth layer 505 and the sixth layer 506 have opposite polarity.

The first layer 501 can be positioned substantially across the third layer 503, the third layer 503 can be positioned substantially across the fifth layer 505, the second layer 502 can be positioned substantially across the fourth layer 504 and the fourth layer 504 can be positioned substantially across the sixth layer 506. The invention also includes all other variations where these layers are not positioned across each other.

The invention is not limited to three regions. The number of regions can be four, five, six, seven, eight, or any other number.

The current flows directly from the anode to the cathode. Under ESD conditions this can cause current crowding at the edge of contacts or doping regions. For a two regions device the current has only one path (for instance from left to right, if the anode is at the left side and the cathode on the right side). A third region places an additional cathode on the left side of the anode. Now the current can flow from the anode to the right and to the left side to the cathode. This reduces the current density per area and thus increases the ESD robustness. As the anode area stays the same which determines the device capacitance the ratio of ESD robustness/capacitance can be improved by a third region.

The first layer 501, the fourth layer 504 and the fifth layer 505 can be of a first type. The second layer 502, the third layer 503 and the sixth layer 506 can be of a second type, opposite to the first type.

The current flows directly from the p part of the first region 511 to the n part of the second region 512. The shorter this path the lower the resistance will be. In ESD applications a low resistive device is of advantage. If a p part of the first region is placed opposite to another p part of the second region this causes the current to flow diagonally to the next adjacent n part of the second region because it is placed a bit lower. This increases the resistance of the device and thus causes a higher clamping voltage. In addition, if the p part is placed above the n part, it could happen that the current is concentrating at the lower end of the p part of the first region and the upper end of the n part of the second region which increases locally the current density which results in a lower ESD robustness.

The first type can be a N type, and the second type can be accordingly a P type. Or, the first type can be a P type, and the second type can be accordingly a N type.

The first region 511 and the third region 513 can be connected to a first pin, and the second region can be connected to a second pin.

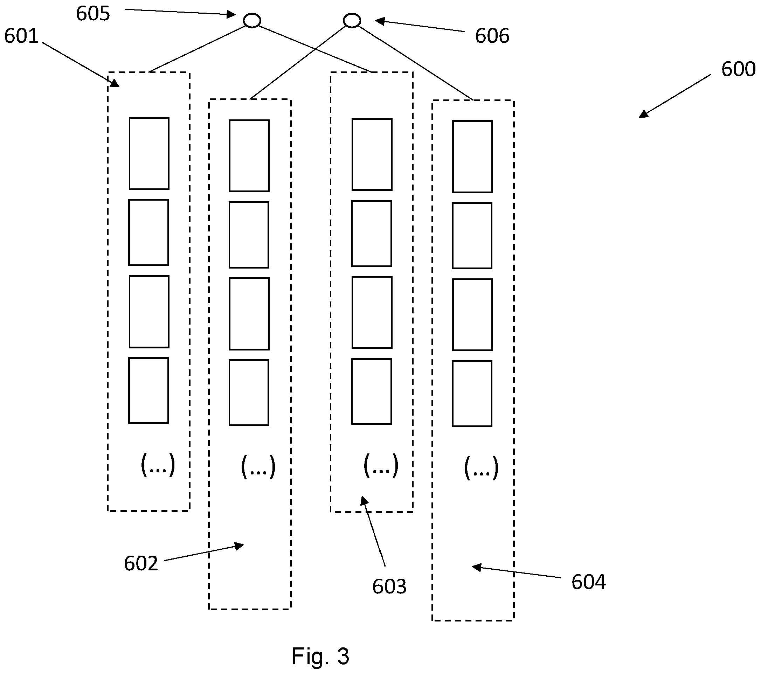

Figure 3 illustrates a semiconductor device 600 according to an embodiment of the present invention. The semiconductor device 600 comprises four regions. The first three regions 601, 602 and 603 are similar to the three regions 511, 512 and 513 described in Figure 2. The fourth region 604 has the same structure as the second region 602. In this exemplary embodiment of the present invention the first region and the third region are connected to a first pin 605, and the second region 602 and the fourth region 604 are connected to a second pin 606.

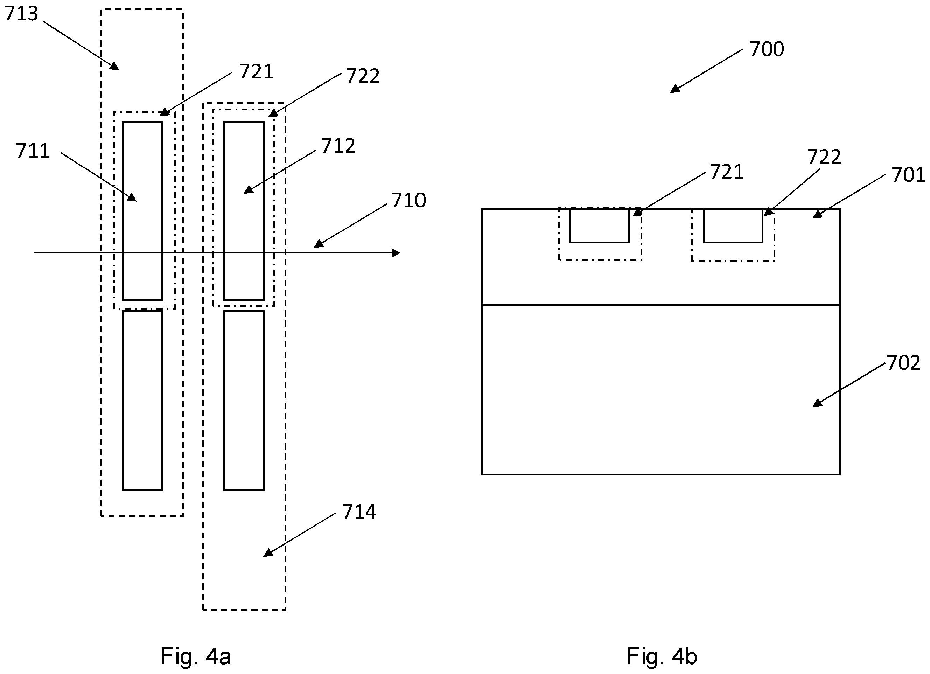

Figures 4a and 4b illustrate a semiconductor device 700 according to an embodiment of the present invention. Figure 4b shows the semiconductor device from Figure 4a with a cut across the line 710. The semiconductor device 700 is similar to the semiconductor devices described in Figures 2 and 3. The first region 713 comprises a first well 721, wherein the polarity of the first well 721 is opposite of the polarity of the first layer 711, and wherein the first well 721 is positioned around the first layer 711. The second region 714 comprises a second well 722, wherein the polarity of the second well is opposite of the polarity of the third layer 712, and wherein the second well 722 is positioned around the third layer 712. The third region can comprise a third well (the third region is not shown in Figures 4a and 4b), wherein the polarity of the third well is opposite of the polarity of the fifth layer, wherein the third well is positioned around the third layer.

According to an embodiment of the invention the length of the first layer 501, the length of the second layer 502, the length of the third layer 503, the length of the fourth layer 504, the length of the fifth layer 505 and the length of the sixth layer 506 can be about the same size.

The first region can comprise of different number of layers, e.g. first eight layers, which first eight layers are of the first type and the second type alternatively. Accordingly the second region can also comprise of second eight layers, which second eight layers are of the second type and the first type alternatively. Finally the third region can comprise of third eight layers, which third eight layers are of the first type and the second type alternatively.

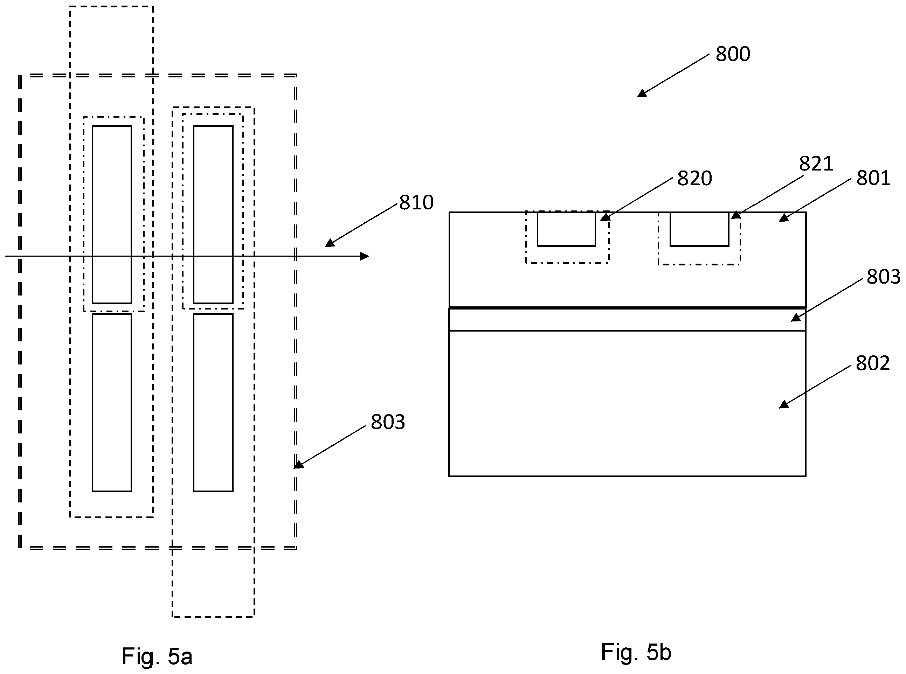

Figures 5a and 5b illustrate a semiconductor device 800 according to an embodiment of the present invention. Figure 5b shows the semiconductor device from Figure 5a with a cut across the line 810. The main structure of this embodiment is similar to the semiconductor device shown in Figures 4a and 4b. The semiconductor device 800 further comprises a doping polarity isolation 801 directly under and around the regions, wherein the doping of the doping polarity isolation is lower than the doping of the wells 820 and 821.

According to an embodiment of the invention the semiconductor device comprises a substrate 802 positioned directly under the doping polarity isolation 801, wherein the doping of the doping polarity isolation 801 is lower than the doping of the substrate 802.

According to an embodiment of the invention the semiconductor device comprises one or more buried layers 803 positioned between the doping polarity isolation 801 and the substrate 802.

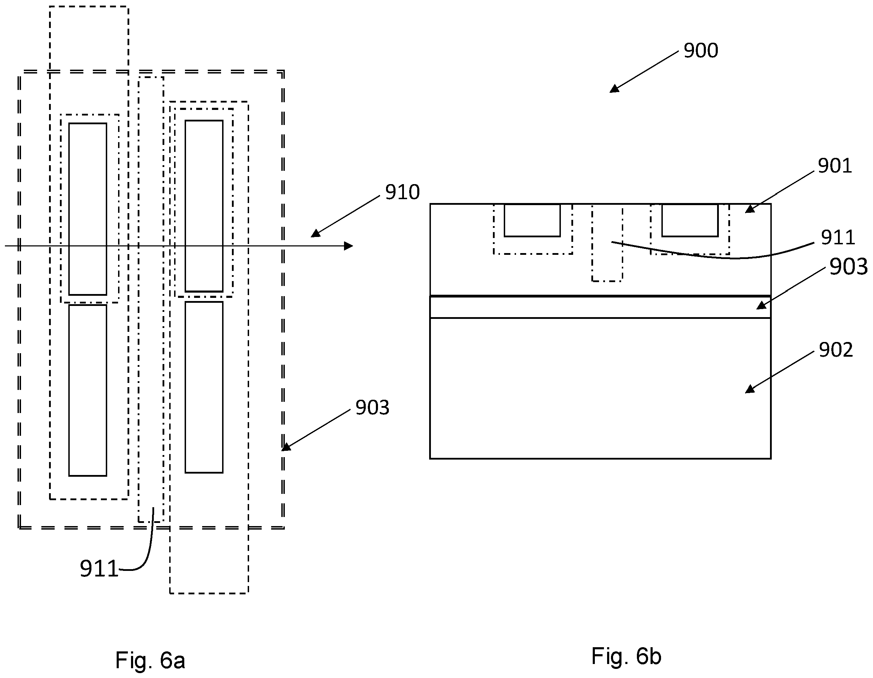

Figures 6a and 6b illustrate a semiconductor device 900 according to an embodiment of the present invention. Figure 6b shows the semiconductor device from Figure 6a with a cut across the line 910. The main structure of this embodiment is similar to the semiconductor device shown in Figures 4a, 4b, 5a and 5b. The semiconductor device 900, next to doping polarity isolation 901, the substrate 902 and buried layer 903, further comprises deep wells 911 between all the regions, which acts as an isolation layer. The buried layer 903 and the deep wells 911 are preferably of the same polarity.

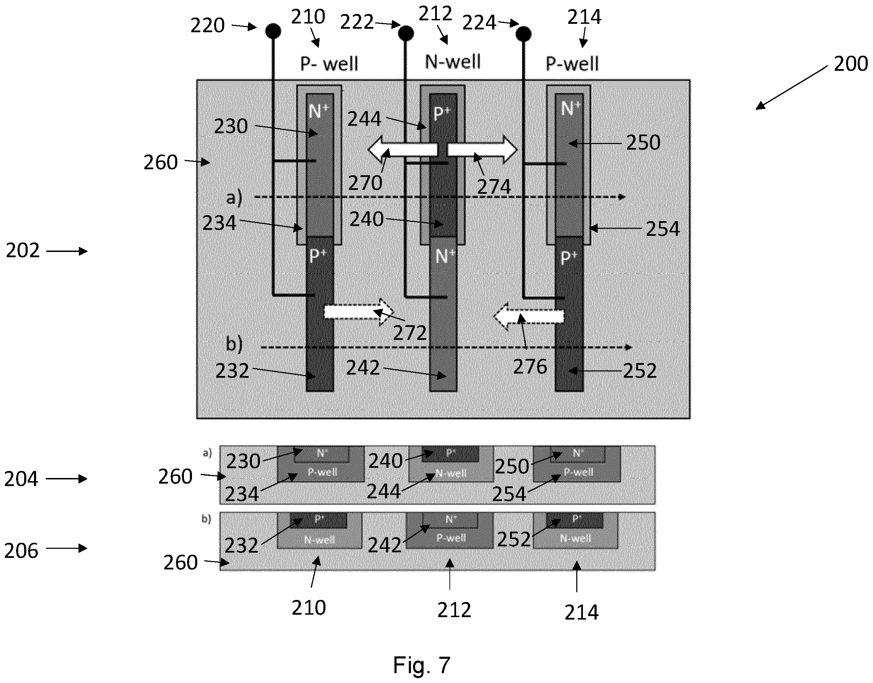

Figure 7 illustrates a semiconductor device 200 according to an embodiment of the present invention.

The semiconductor device 200 is shown in a top view marked with the reference number 202 in Figure 7, a first side view across line a) in Figure 7 marked with the reference number 204 in Figure 7, and a second side view across line b) in Figure 7 marked with the reference number 206 in Figure 7.

The semiconductor device comprises three regions, a first region/a first finger 210, a second region/a second finger 212, and a third region/a third finger 214. These three regions/fingers 210, 212 and 214 are positioned horizontally next to each other, as shown in Figure 7.

The semiconductor device can comprise a P- area 260 wherein these three regions 210, 212 and 214 are positioned.

The first region 210 comprises a first N+ layer 230, a first P+ layer 232 and a first P-well 234 around the first N+ layer 230. The first N+ layer 230 and the first P+ layer 232 are positioned in a continued way (i.e. laterally along the first finger 210), or vertically in respect to each other, as shown in Figure 7. In the exemplary embodiment shown in Figure 7 the first N+ layer 230 and the first P+ layer 232 are about the same length. However, the invention includes all suitable and applicable length ratios between the first N+ layer 230 and the first P+ layer 232 within the first region 210.

The second region 212 comprises a second P+ layer 240, a second N+ layer 242 and a second N-well 244 around the second P+ layer 240. The second P+ layer 240 and the second N+ layer 242 are positioned in a continued way (i.e. laterally along the second finger 212), or vertically in respect to each other, as shown in Figure 7. In the exemplary embodiment shown in Figure 7 the second P+ layer 240 and the second N+ layer 242 are about the same length. However, the invention includes all suitable and applicable length ratios between the second P+ layer 240 and the second N+ layer 242 within the second region 212.

The second region 212 is positioned horizontally across the first region 210, as shown in Figure 7. The second P+ layer 240 and the second N+ layer 242 are positioned horizontally across the first N+ layer 230 and the first P+ layer 232, respectively, as shown in Figure 7.

The third region 214 comprises a third N+ layer 250, a third P+ layer 252 and a third P-well 254 around the third N+ layer 250. The third N+ layer 250 and the third P+ layer 252 are positioned in a continued way (i.e. laterally along the third finger 214), or vertically in respect to each other, as shown in Figure 7. In the exemplary embodiment shown in Figure 7 the third N+ layer 250 and the third P+ layer 242 are about the same length. However, the invention includes all suitable and applicable length ratios between the third N+ layer 250 and the third P+ layer 252 within the third region 214.

The third region 214 is positioned horizontally across the second region 212, as shown in Figure 7. The third N+ layer 250 and the third P+ layer 252 are positioned horizontally across the second P+ layer 240 and the second N+ layer 242, respectively, as shown in Figure 7.

The semiconductor device further comprises three pins, a first pin 220 connected to the first region 210, a second pin 222 connected to the second region 212 and a third pin 224 connected to the third region 214.First and third pin may be electrically connected.

Such positioning of N+ and P+ layers 230, 232, 240, 242, 250 and 252 in the three regions 210, 212 and 214 as shown in Figure 7, secures that a current is flowing in both directions. The current is flowing:
- from the second P+ layer 240 towards the first N+ layer 230, as indicated with a first arrow with the reference sign 270, and
- from the second P+ layer 240 towards the third N+ layer 250, as indicated with a second arrow with the reference sign 274.

The current can alternatively flow:
- from the first P+ layer 232 towards the second N+ layer 242, as indicated with a third arrow with the reference sign 272, and
- from the third P+ layer 252 towards the second N+ layer 242, as indicated with a fourth arrow with the reference sign 276.

Thus, the top part of the layers is active for one polarity and the bottom part of the layers is active for the other polarity. For a positive polarity on pin 1 (reference sign 222) the SCR in the upper part of the semiconductor device will be active and the current can flow in the upper part, the reference signs 270 and 274. For a positive polarity on pin 2 (reference signs 220 and 224) the forward biased diode in the lower part of the semiconductor device will be active and the current can flow in the lower part, the reference signs 272 and 276.

The semiconductor device 200 according to this embodiment of the present invention has a significant advantage that a width of the second N-well 244 can be decreased, which means that the capacitance of the semiconductor device 200 will be decreased. Such a junction capacitance of the semiconductor device 200 will be reduced by at least 15-20%, while the same an ESD robustness of the semiconductor device 200 will be maintained.

This is significant advantage compared to the semiconductor devices known in the art, since the system level ESD protection of the semiconductor device 200 has a lower capacitance so to maintain signal integrity of high speed data lines. Doping layers as described in the embodiments of the present invention allows to reduce the capacitance of the device for at least 15-20%.

For slower pulses such as the 8/20 surge pulse a homogeneous triggering of different SCR fingers, i.e. three regions explained above, becomes important. Which SCR finger triggers first depends on factors which cannot be controlled. Therefore, it must be made sure that the adjacent fingers start to trigger sufficiently quick to so improve the surge robustness. The embodiments of the present invention make the layout of the semiconductor device more symmetric, which helps to avoid problems with adjacent finger triggering.

In an embodiment of the present invention a N-well and a P-well are used, in which N-well and P-well the contact regions are placed, which is an unidirectional SCR. In other embodiment of the present invention two N-wells are used and a punch through stopper in between the two N-wells, which is a bidirectional SCR.

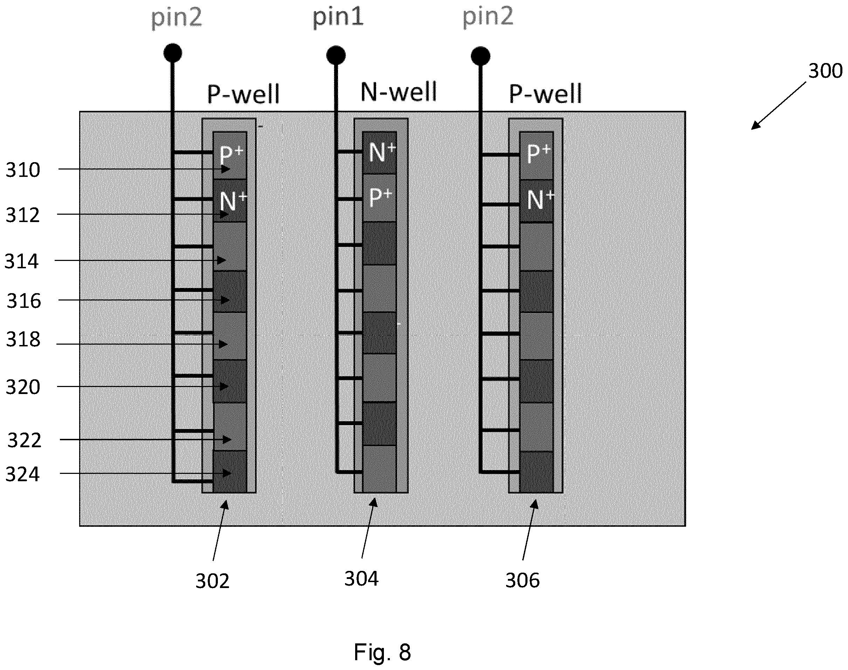

In embodiment of the present invention shown in Figure 8, the three regions 302, 304 and 306 can comprise multiple N+ and P+ alternating layers/regions, i.e. the three regions are divided into many laterally aligned regions/layers/segments.

The first region 302 comprises in this exemplary embodiment a first P+ segment 310, a second N+ segment 312, a third P+ segment 314, a fourth N+ segment 316, a fifth P+ segment 318, a sixth N+ segment 320, a seventh P+ segment 322, and an eighth N+ segment 324.

The second region 304 and the third region 306 have a similar structure as the first region 302, as shown in Figure 8.

In this exemplary embodiment each of the three regions 302, 304 and 306 comprises 8 segments. The present invention covers also any other applicable number of the segments within the three regions 302, 304 and 306.

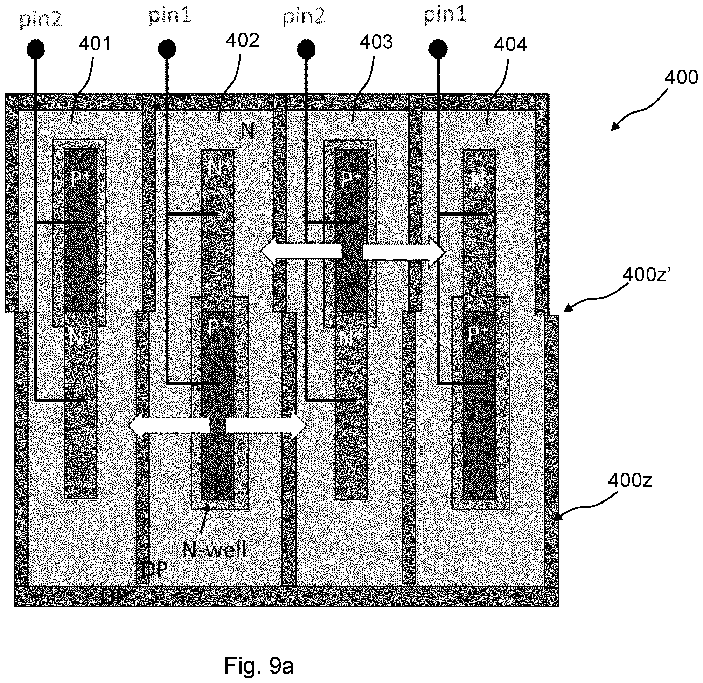

A semiconductor device 400 according to an embodiment of the present invention is shown in Figures 9A-9D. The semiconductor device 400 is similar to the semiconductor device 200 as shown in Figure 7.

The semiconductor device 400, as shown in Figure 9A-9D, comprises four regions, wherein the semiconductor device further comprises a deep well (DP) isolation 400z around the four regions.

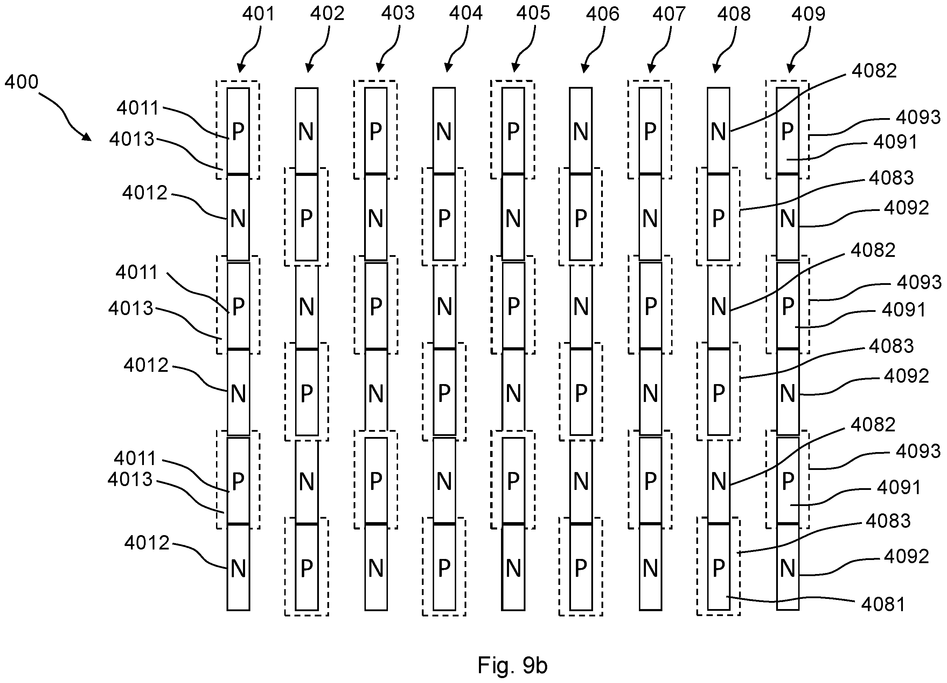

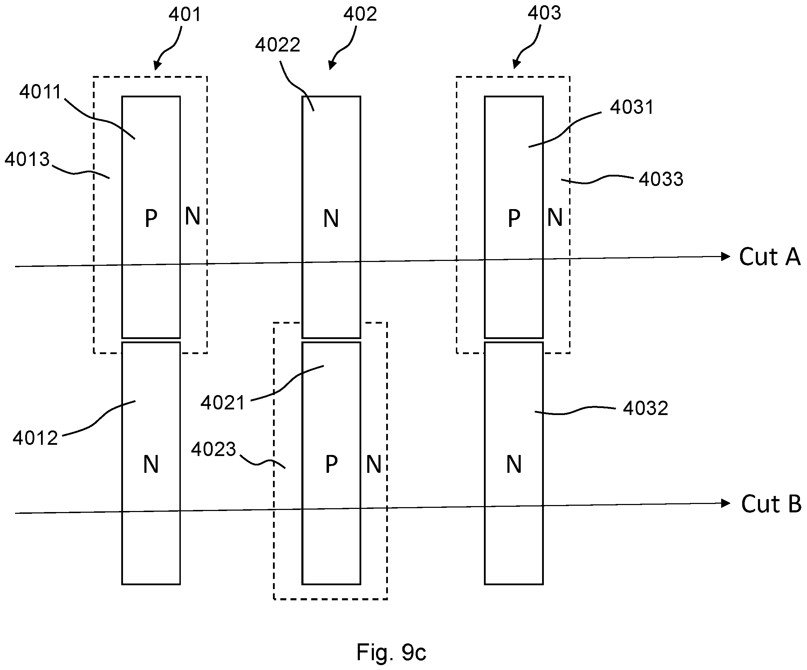

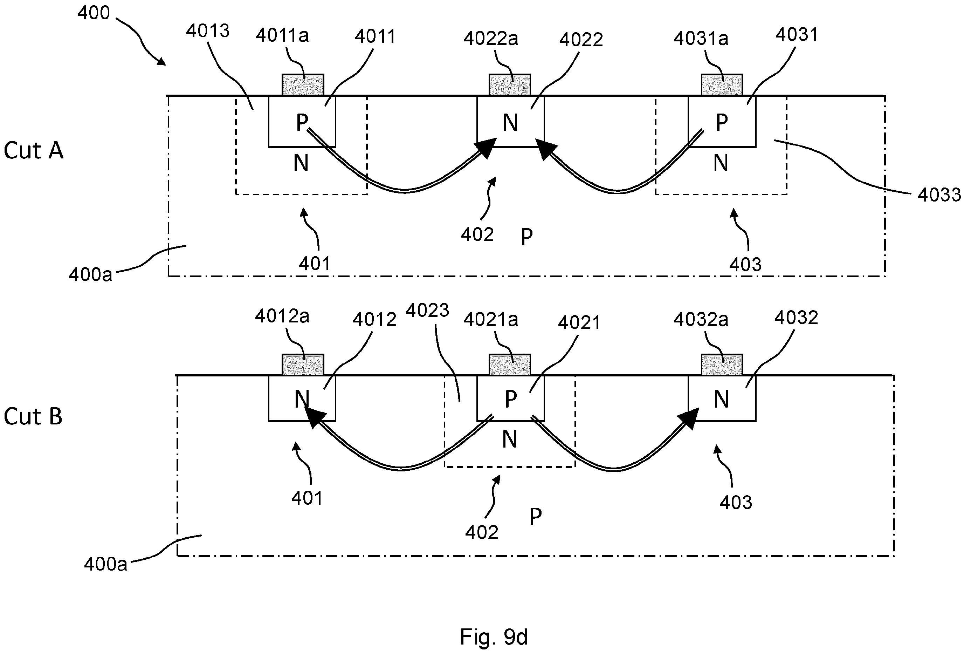

The DP isolation layout 400z can be implemented in stepwise way, as indicated by the reference sign 400z' in Figure 9.

However, the implementation of this embodiment depends on the doping polarity of an epitaxial region/substrate. If the epi/substrate polarity would be of a P-type and the DP of N-type, the stepwise layout 400z' could be omitted.

Also this embodiment of the present invention secures that the junction capacitance of the semiconductor device 400 is reduced by at least 15-20% while the same ESD robustness of the semiconductor device 400 is maintained.

According to the disclosure of Figures 9A-9D, the semiconductor device 400 at least three regions, in Figure 9A indicated with reference numerals 401-402-403-404. In Figure 9B a multi-region example of the semiconductor device 400 is depicted, which configuration incorporated nine regions, marked 401, 402, 403, 404, 405, 406, 407, 408 and 409. The disclosure is not limited to three regions. The number X of regions (fingers) can be four, five, six, seven, eight, or any other number, and preferably an odd number.

Each region / finger (40X, with X being the number of the region in the configuration) comprises a first-type layer 4011 (in particular 40X1, with X being the number of the region in the configuration). Each first-type layer 40X1 is doped with a first type of charge carriers. Each region 40X also comprises a second-type layer 40X2 (with X being the number of the region in the configuration) doped with a second type of charge carriers, The first-type layer 40X1 and the second-type layer 40X2 are positioned laterally along each region 40X.

The first-type layer 40X1 and the second-type layer 40X2 have opposite polarity. Accordingly, the first type of charge carriers may be P-type carriers, whereas the second type of charge carriers may be N-type carriers. However, the reversed configuration, wherein the first type of charge carriers are N-type carriers and the second type of charge carriers are P-type carriers is equally appliable in achieving the desired effect.

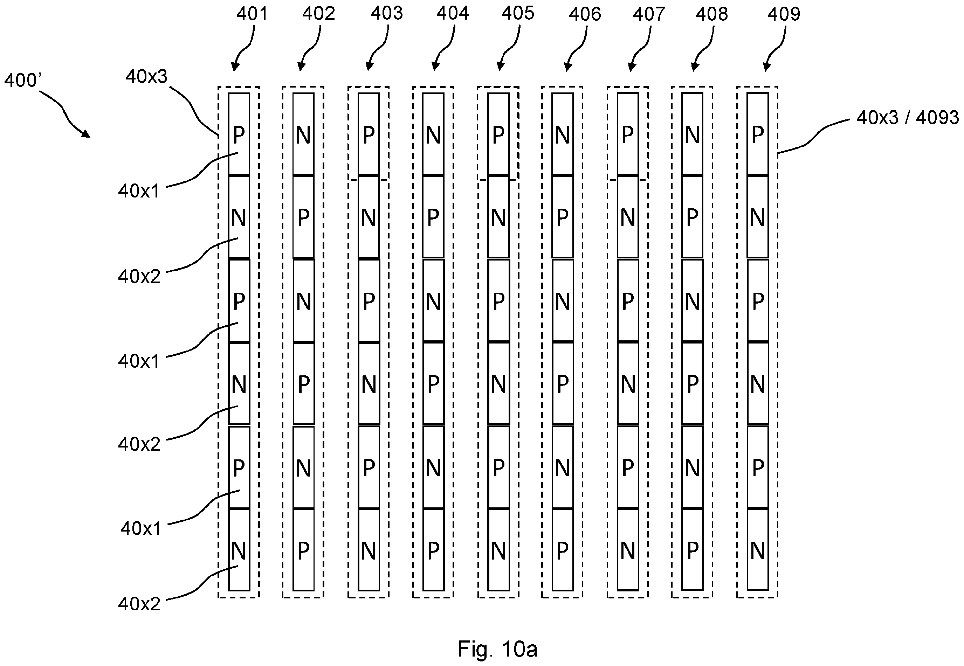

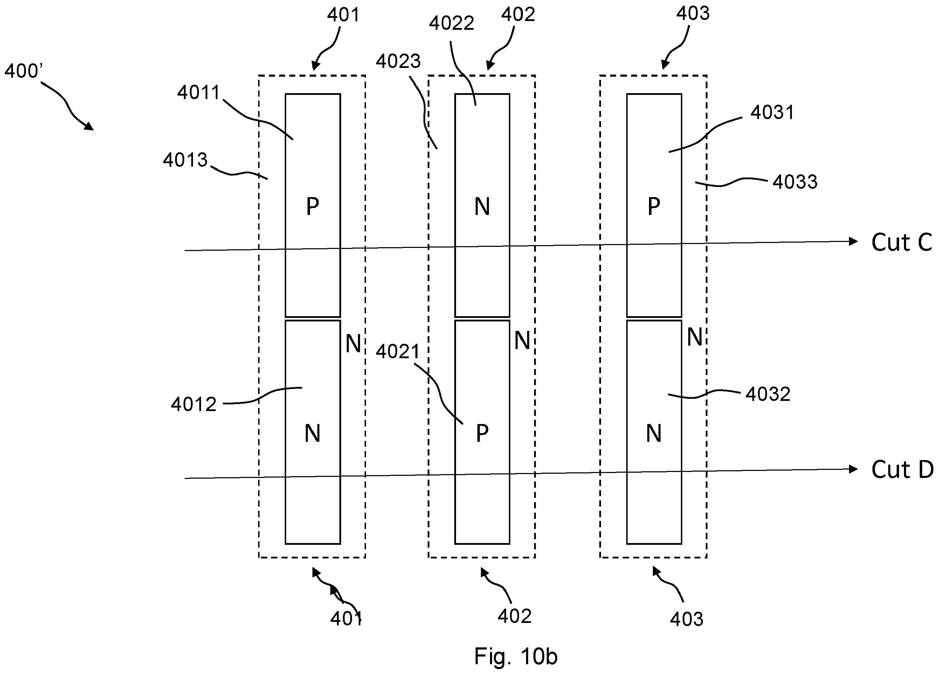

As shown in Figures 9A and 9B (and Figures 10A-10B), the first-type layer 4011 of the first region 401 is positioned substantially across the second-type layer 4022 of the neighboring second region 402, and the second-type layer 4012 of the first region 401 is positioned substantially across the first-type layer 4021 of the neighboring region 402. In other words, first-type layers 40X1 of region 40X alternatingly adjoin or are positioned substantially across second-type layers 40(X±1)2 of adjacent regions 40(X±1).

Additionally, as shown in Figures 9C and 9D, each region 40X comprises a second-type well 40X3 (with X being the number of the region in the configuration) doped with the second type of charge carriers. The second-type well 40X3 is positioned within a substrate 400a doped with the first type of charge carriers and around at least the first-type layer 40X1.

The alternate orientation of the multiple, so-called fingers / regions 40X, with each finger/region 40X being segmented in first-type and second-type layers 40X1-40X2 result in segments functioning as a two-sided SCRs. Accordingly, a bidirectional SCR with lower capacitance is obtained.

Accordingly, and depending on the polarity of the first-type and second type charge carriers used, a current will flow within each region 40X being segmented in first-type and second-type layers 40X1-40X2 result in segments functioning as a two-sided SCRs, see the arrows depicting the bi-directional direction of the current flow within the regions from or to adjacent regions.

Depending on the polarity used of the first-type and second-type charge carriers, current will either flow in the first segment (first layer) or in the second segment (second layer) formed. In particular, see Cut B of Figure 9D, the current flows directly from the first-type layer 4021 of region 402 to the adjacent second-type layers 4012 and 4032 of adjacent regions 401 and 403. Likewise, in Cut A of Figure 9D, the current flows directly from the first-type layers 4011 and 4031 of regions 401-403 to the adjacent second-type layer 4022 of adjacent region 402. The shorter this path the lower the resistance will be.

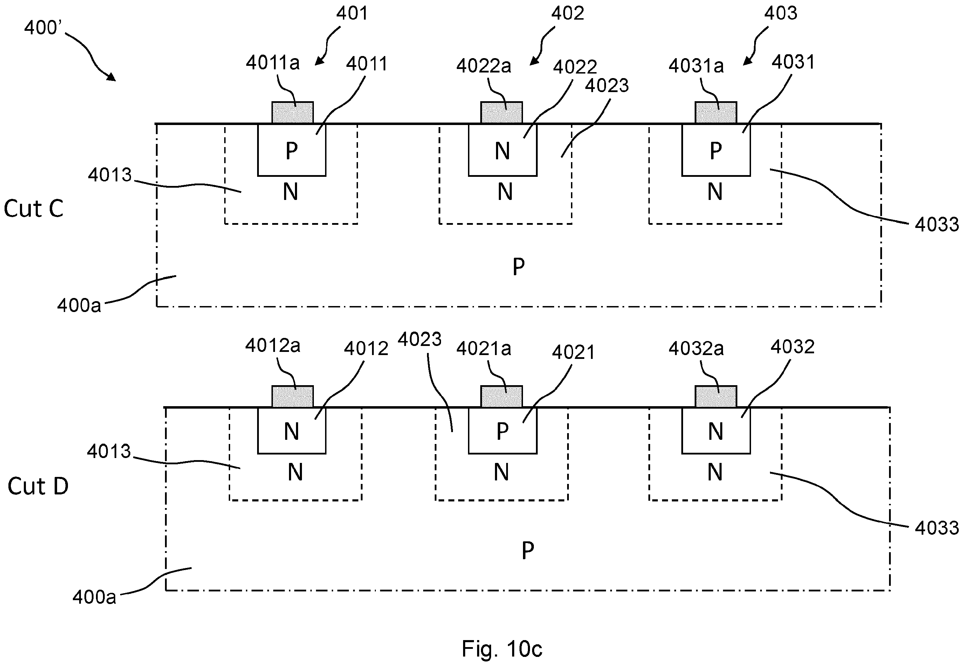

In Figures 9D, but also in Figures 10C, 11B and 12B, each first-type layer 40X1 and second-type layer 40X2 of a respective region 40X is provided with contact terminals 40X1a or 40X2a, respectively. In a similar fashion as shown in Figure 9A, the device may comprise a first pin (PIN1) and a second pin (PIN2), wherein the regions 40X alternatingly are connected to the first pin and the second pin, respectively. In Figure 9A and 10A, it is depicted more clearly: all first-type layers and second-type layers of the odd numbered regions (401, 403, 405, etc.) are connected to one (second) outer contact pin PIN2, whereas all first-type layers and second-type layers of the even numbered regions (402, 404, 406, etc.) are connected to the other (first) outer contact pin PIN1.

In a further example 400', see Figures 10A-10B-10C, in each region 401, 402, 403, 404, 405, 406, 407, 408 and 409, the second-type well 40X3 is continuous and thus also positioned around the second-type layers 40X2, next to the first-type layers 40X1. See also the cross section of Figure 10C, Cut C and Cut D.

Throughout the Figures of the disclosure, the length of the first-type layers 4012 and the length of the second-type layers 40X2 are about the same size.

Preferably, each region 40X comprises N, with N a natural number greater than two (2), layers 40X1-40X2, which N layers are of the first-type layer 40X1 and the second-type layer 40X2 alternatively. Such alternating configuration of the layers 40X1-40X2 within each region 40X but also across adjacent regions 40X is shown in Figure 9B and 10A. Likewise, the number of segments (first-type and second type layers 40X1-40X2) can be any number N, but preferable an even number, hence an equal number of first-type layers 40X1 and second-type layers 40X2 alternatingly orientated in lateral direction along each region 40X.

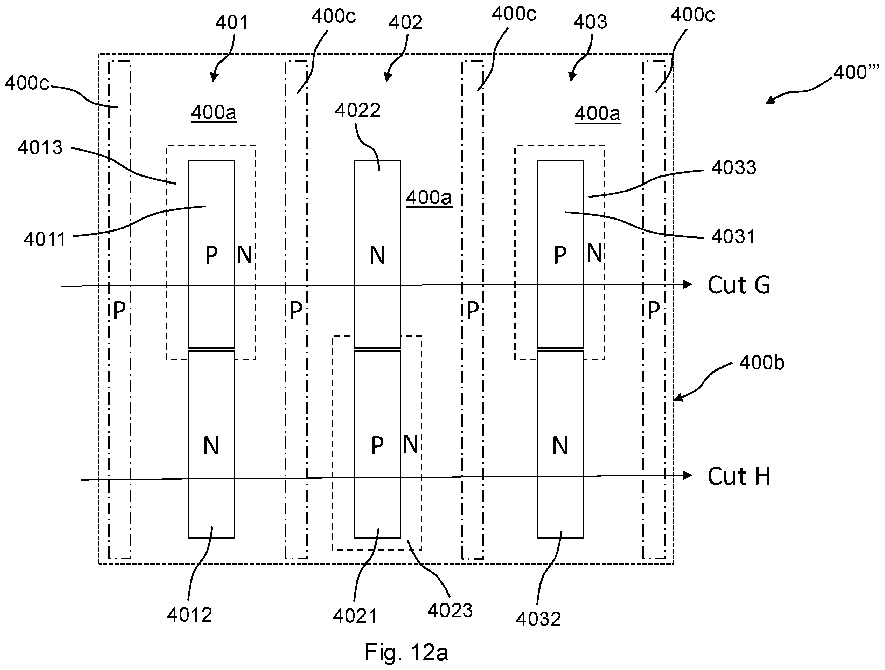

Alternatively, in another example of the disclosure depicted in Figures 12A-12B, the semiconductor device 400'" comprises a first-type substrate 400a doped with the first type of charge carriers and a first-type buried layer '400b doped with the first type of charge carriers. See Figure 12A-12B, wherein, in a preferred example, the doping of the first-type buried layer 400b is higher than the doping of the first-type substrate 400a.

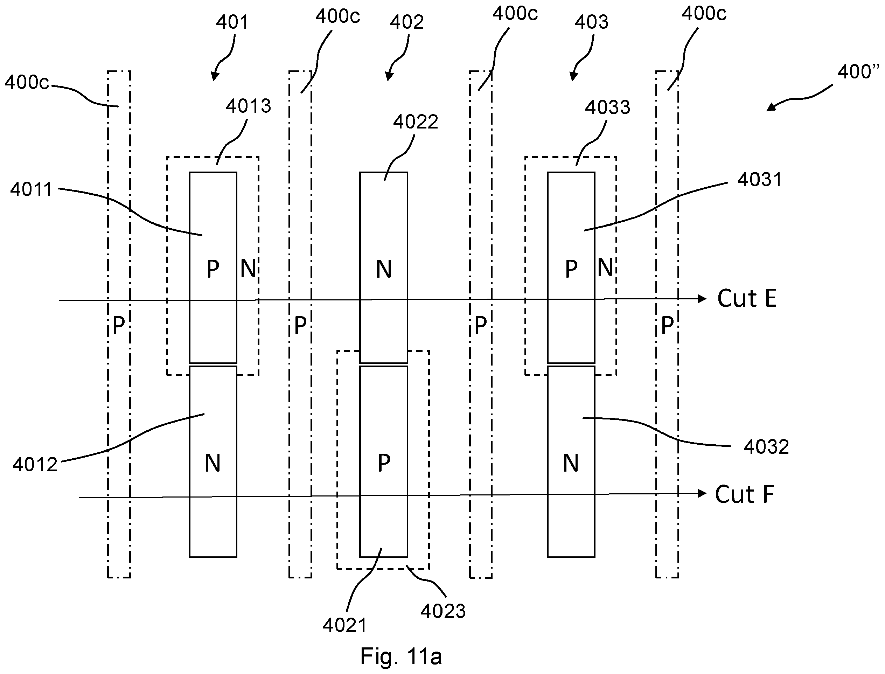

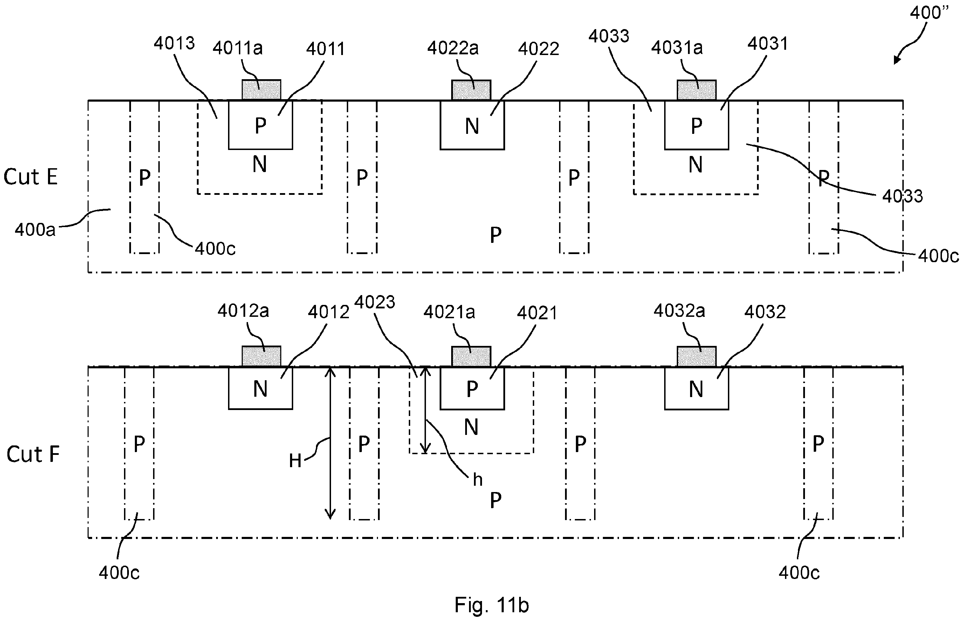

In a further advantageous example, depicted in Figures 11A-11B, the semiconductor device 400" comprises first-type deep wells 400c doped with the first type of charge carriers between all the regions 40X. These additional deep wells 400b are advantageous when the doping level of the first-type substrate 400a is so small, that without the deep wells 400b punch-through effects would occur between the second-type dopings of the second-type wells 40X3 in neighboring regions 40X. With the additional first-type deep wells 400c the doping level of the first-type substrate 400a can be reduced to a very low level. This reduces the capacitance of the second-type well/substrate junction 401a-403a (40Xa) and of the second-type contact diffusion/substrate junction 402b (40Xb). This allows to reduce the overall capacitance of the whole device structure.

Preferably, the depth H of the first-type deep wells 400c is larger than the depth h of the second-type wells 40X3.

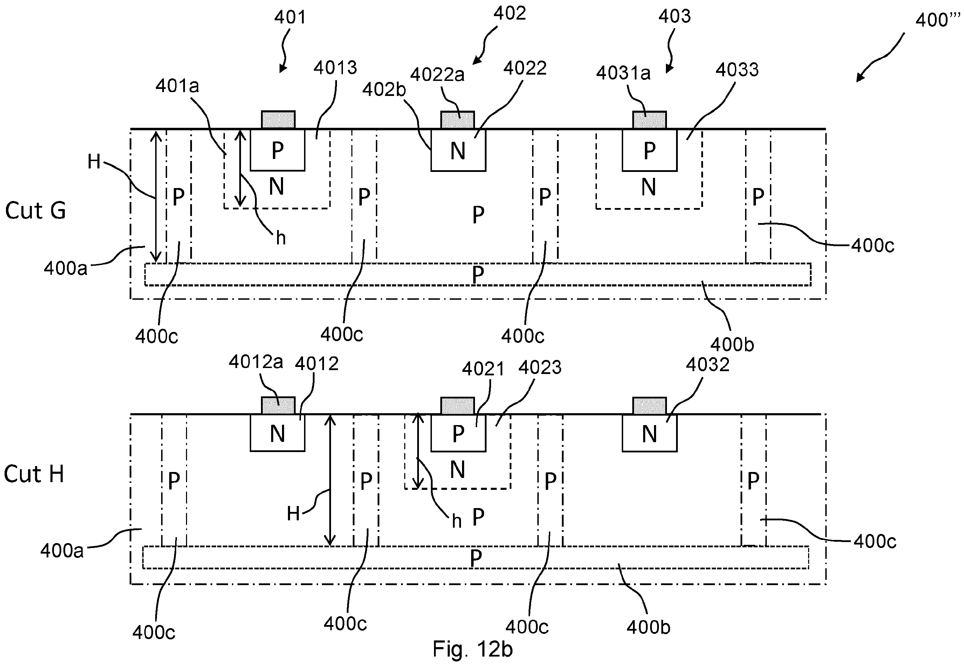

Advantageously, the first-type buried layer 400b is electrically connected with the first-type deep wells 400c, see Figure 12B.

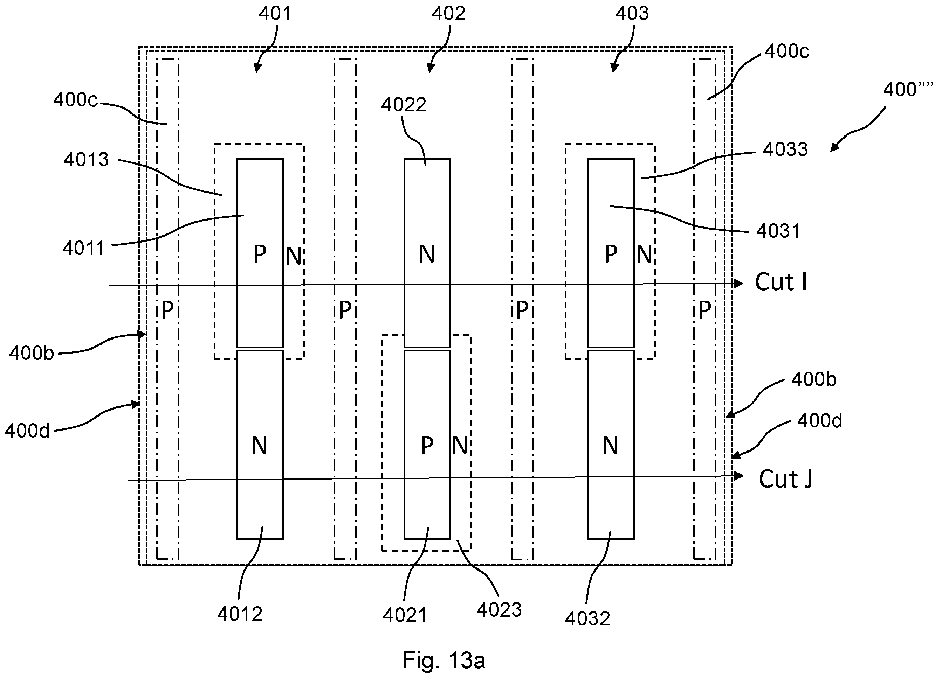

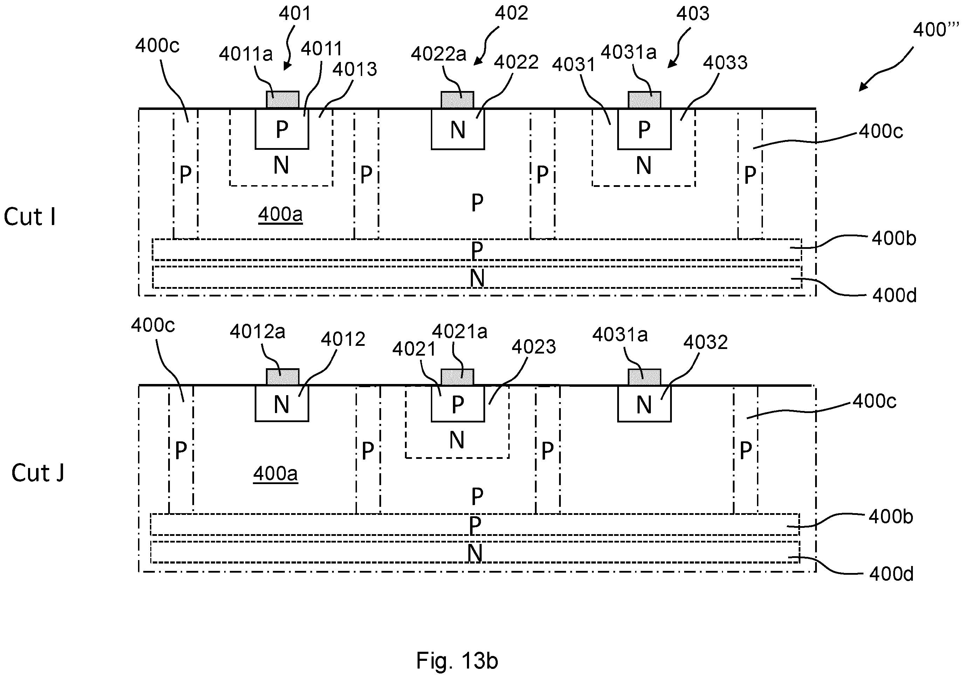

In a further example of a semiconductor device 400"" according to the disclosure, shown in Figures 13A-13B, it comprises a second-type buried layer 400d doped with the second type of charge carriers positioned below the first-type buried layer 400b. Additionally, the semiconductor device 400"" may be placed on an oxide layer, which serves as an electrical isolation from the bottom side of the semiconductor device.

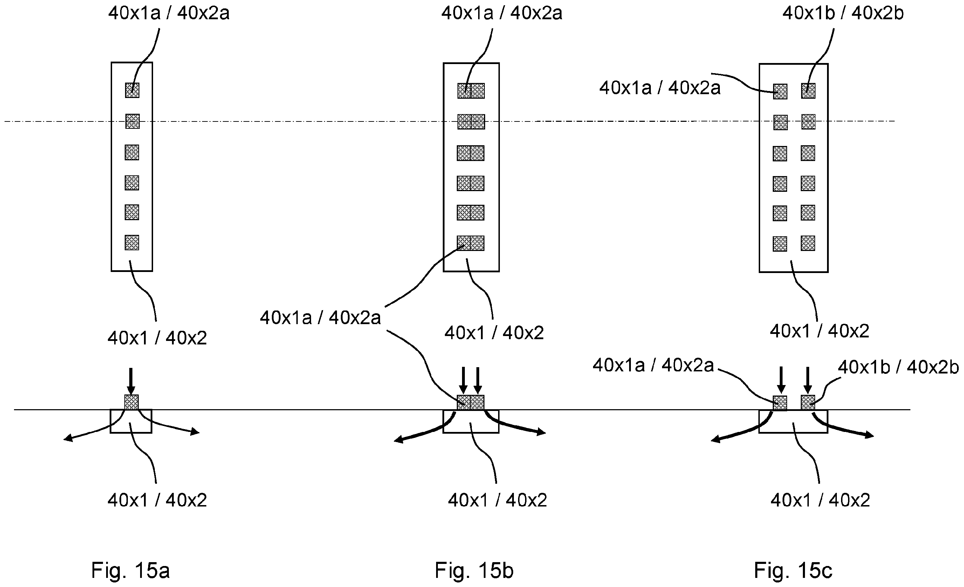

In a further example, each first-type layer 40X1 and second-type layer 40X2 is provided with at least one row of multiple spaced-apart electrically interconnected contact terminals 40X1a-40X2a. See Figure 15A, where the contact terminals 40X1a-40X2a have a square configuration.

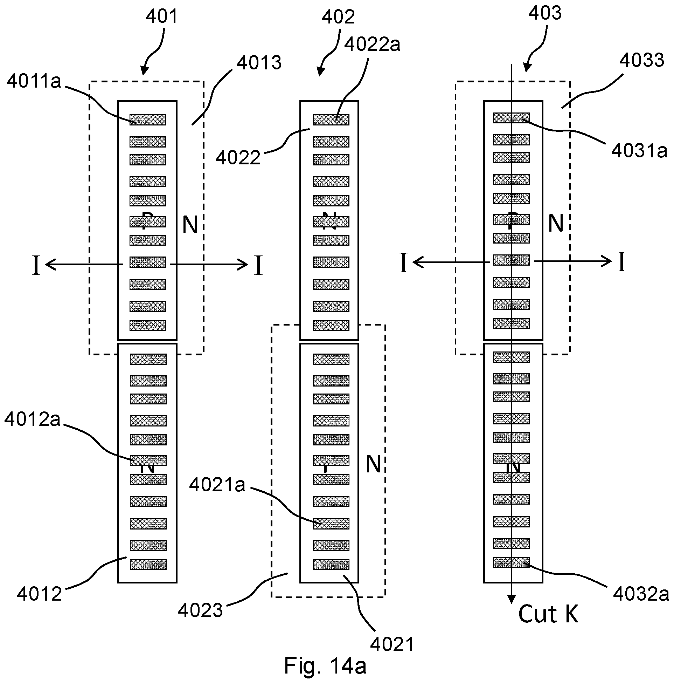

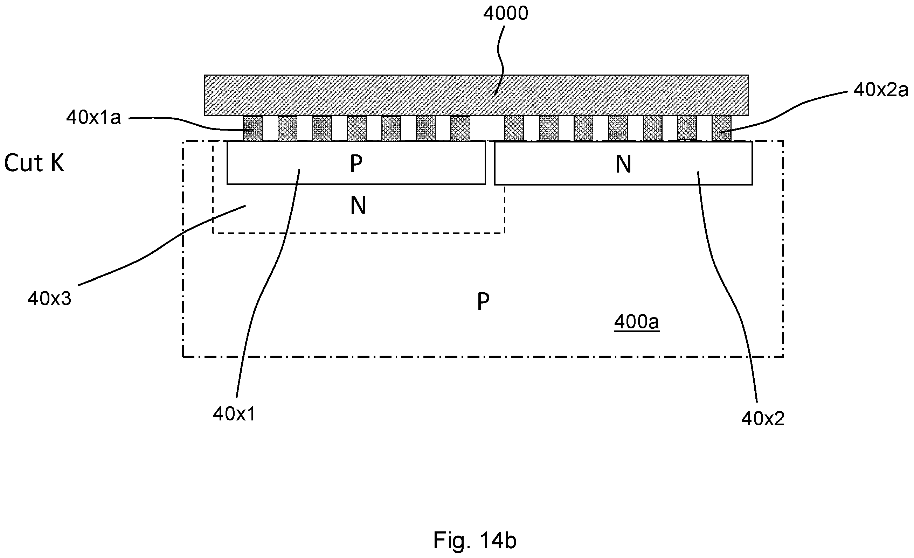

A metal interconnect 4000 may connect the contact terminals 40X1a-40X2a to their respective first PIN1 or second PIN2, see Figure 14B. The metal interconnect 4000 may interconnect all regions, however for beneficial performance of the device some regions are not connected. The long side (length) of the contact terminals is perpendicular to the longitudinal dimension of each region 40X, and the small side (width) is oriented in the direction of the current flow I (see arrows I in Figure 14A). The length to width ratio of the contact terminals is in the range of 1.5 to 3, preferably 2. It has been found, that providing the multiple spaced-apart electrically interconnected contact terminals 40X1a-40X2a as rectangular contacts, see Figure 14A and 15B, that this configuration offers the best compromise between current robustness and parasitic capacitance with current flowing to both sides of the contacts, see the arrows depicted in Figures 15A and 15B.

In particular, see Figure 15C, each first-type layer and second-type layer may be provided with two parallel rows of multiple spaced-apart electrically interconnected contact terminals 40X1a/40X2a-40X1b/40X2b. A dual row 40X1a-40X1b / 40X2a-40X2b of contact terminals allows for more current in the contacts, however also the parasitic capacitance is larger because the contact diffusion has to be wide in order to accommodate the two rows of contact terminals. Rectangular contacts have a large current robustness, and the parasitic capacitance can be low because the contact diffusions can be narrower than with two rows of contacts.

The disclosure also pertains to a method of producing a semiconductor device as outlined in this patent application.

As shown in the exemplary embodiments of the present invention, it is possible to reduce the area and thereby also the capacitance of the lowly doped junction regions of the semiconductor device. In addition, the layout of the semiconductor service becomes more symmetric and therefore the triggering of adjacent fingers/regions/layers of the semiconductor device is not dependent on the position of the first triggered finger/region/layer.

Such a laterally segmented layout of an SCR, as described in the above embodiments of the present invention, allows to reduce the capacitance of the ESD protection semiconductor device. In addition, it allows that the current spreading between the SCR fingers occurs more homogeneously.

Buried layers can be placed below the structures for improved isolation to the substrate.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- at least three regions,
- wherein each region comprises a first-type layer doped with a first type of charge carriers and a second-type layer doped with a second type of charge carriers, wherein first-type layer and the second-type layer are positioned laterally along each region, wherein the first-type layer and the second-type layer have opposite polarity,
- wherein the first-type layer of a region is positioned substantially across the second-type layer of a neighboring region, and the second-type layer of a region is positioned substantially across the first-type layer of a neighboring region and wherein
- each region comprises a second-type well doped with the second type of charge carriers, wherein the second-type well is positioned around at least the first-type layer.

2. A semiconductor device as claimed in claim 1, wherein, in each region, the second-type well is also positioned around the second-type layer.

3. A semiconductor device as claimed in claim 1 or 2, wherein the first type of charge carriers are N type carriers, and the second type of charge carriers are P type carriers or wherein the first type of charge carriers are P type carriers, and the second type of charge carriers are N type carriers.

4. A semiconductor device as claimed in any of the previous claims, further comprising a first pin and a second pin, wherein the regions alternatingly are connected to the first pin and the second pin, respectively.

5. A semiconductor device as claimed in any of the previous claims, wherein the length of the first-type layer and the length of the second-type layer are about the same size.

6. A semiconductor device as claimed in any of the previous claims, wherein each region comprises N, with N a natural number greater than 2, layers, which N layers are of the first-type layer and the second-type layer alternatively.

7. A semiconductor device as claimed in any of the previous claims, wherein the semiconductor device comprises a first-type substrate doped with the first type of charge carriers and a first-type buried layer doped with the first type of charge carriers.

8. A semiconductor device as claimed in claim 7, wherein the doping of the first-type buried layer is higher than the doping of the first-type substrate.

9. A semiconductor device as claimed in any of the previous claims, wherein the semiconductor device comprises first-type deep wells doped with the first type of charge carriers between all the regions.

10. A semiconductor device as claimed in claim 9, wherein the depth of the first-type deep wells is larger than the depth of the second-type wells.

11. A semiconductor device as claimed in any of the claims 7-10, wherein the first-type buried layer is electrically connected with the first-type deep wells.

12. A semiconductor device as claimed in any of the claims 7-11, wherein the semiconductor device comprises a second-type buried layer doped with the second type of charge carriers positioned below the first-type buried layer.

13. A semiconductor device as claimed in any of the preceding claims, wherein the semiconductor device is placed on an oxide layer.

14. A semiconductor device as claimed in any of the preceding claims, wherein each first-type layer and second-type layer is provided with at least one row of multiple spaced-apart electrically interconnected contact terminals.

15. A semiconductor device as claimed in claim 14, wherein the contact terminals have a rectangular configuration.

16. A method of producing a semiconductor device as claimed in any of the previous claims.
